# EUROPÄISCHE PATENTSCHRIFT

(11) **EP 1 343 926 B1**
(45) Veröffentlichungstag und Bekanntmachung des Hinweises auf die Patenterteilung: **27.04.2005**
(21) Anmeldenummer: 01984799.5
(22) Anmeldetag: 01.12.2001
(51) Int. Cl.: C30B 25/14, C23C 16/44

(54) **VERFAHREN ZUM ABSCHEIDEN INSBESONDERE KRISTALLINER SCHICHTEN**
METHOD FOR DEPOSITING ESPECIALLY CRYSTALLINE LAYERS
PROCEDE DE DEPOT DE COUCHES NOTAMMENT CRISTALLINES

(30) Priorität: 23.12.2000 DE 10064942
(43) Veröffentlichungstag der Anmeldung: 17.09.2003
(73) Patentinhaber: Aixtron AG, 52072 Aachen (DE)
(72) Erfinder: DAUELSBERG, Martin, 52064 Aachen (DE)
(74) Vertreter: Grundmann, Dirk, Dr.
(86) Internationale Anmeldenummer: PCT/EP2001/014064
(87) Internationale Veröffentlichungsnummer: WO 2002/052069

(56) Entgegenhaltungen:
- US-A- 4 976 217
- US-A- 5 027 746

## Beschreibung

Die Erfindung betrifft ein Verfahren zum Abscheiden von insbesondere kristallinen Schichten auf insbesondere kristallinen Substraten gemäß Gattungsbegriff des Anspruchs 1.

Die Erfindung betrifft darüber hinaus eine Vorrichtung zum Abscheiden von insbesondere kristallinen Schichten auf insbesondere kristallinen Substraten gemäß Gattungsbegriff des Anspruchs 2.

Eine gattungsgemäße Vorrichtung beschreibt das US-Patent 5,027,746. Beschrieben wird dort eine Vorrichtung zum epitaktischen Wachstum von III-V-Halbleiterschichten. Dort werden die Prozessgase zentral einer Prozesskammer zugeführt, deren Boden beheizt ist. Die Prozessgase werden durch einen die Prozesskammer umgebenden Gasauslassring abgeführt. Auch bei dieser Vorrichtung werden Spalte zwischen den einzelnen Bauteilen der Prozesskammer mittels Spülgasen gespült. Insbesondere wird hier der Zwischenraum zwischen dem Reaktordeckel und der Prozesskammerdecke mit einer Mischung von Wasserstoff und Argon gespült. Durch Variation der Gaszusammensetzung kann die thermische Leitfähigkeit des Spülgases, und damit die Kühlung der Prozesskammerdecke beeinflusst werden.

Das US-Patent 4,976,217 beschreibt ein Verfahren bzw. eine Vorrichtung zum Abscheiden von III-V-Halbleiterschichten in einem Reaktor, welcher zylindersymmetrisch ausgebildet ist. Die Prozesskammer besitzt einen Boden, der von unten her mit Hochfrequenz beheizt wird. Die Prozesskammer wird von einem ringförmigen Hohlkörper umgeben, welcher radial einwärts gerichtete Öffnungen besitzt, durch welche das zentral in die Prozesskammer eingeleitete Prozessgas abgeführt wird. Der rückwärtige, radial außenliegende Raum um diesen Gasauslassring wird von eine kalten Reaktorwand umgeben. Der Spalt der Reaktorwand und dem Gasauslassring wird mit einem Spülgas gespült.

Bei einer gattungsgemäßen Vorrichtung ist es zweckdienlich, wenn zum Beladen der Prozesskammer, wozu der Reaktordeckel und die daran befestigte Prozesskammerdecke angehoben werden, ein Gasauslassring abgesenkt wird. Beim Absenken des Gasauslassringes kann es zu einer unerwünschten Partikelfreisetzung kommen. Die Partikel werden insbesondere aus den Gasauslassöffnungen des Gasauslassringes freigesetzt und entstammen einer parasitären Belegung des Inneren des Gasauslassringes.

Der Erfindung liegt die Aufgabe zugrunde, das Verfahren so zu führen, dass die Partikelbelegung reduziert wird. Gelöst wird die Aufgabe durch die in den Ansprüchen angegebene Erfindung.

Der Anspruch 1 schlägt vor, dass das den Raum zwischen der Reaktorwand und dem Gasauslassring spülende Gas Stickstoff oder eine Mischung aus Wasserstoff und Stickstoff ist. Die erfindungsgemäße Lösung beruht auf der Erkenntnis, dass das parasitäre Wachstum innerhalb des hohlen Gasauslassrings und im Bereich des Spaltes zwischen Gasauslassring und dem den Gasauslassring bereichsweise überfangenden Randabschnitt der Prozesskammerdecke durch eine zu niedrige Wandtemperatur bzw. durch Diffusion eines Prozessgases in den Spalt erfolgt. Durch die Wahl des Spülgases wird nicht nur dessen thermische Leitfähigkeit verkleinert. Einhergehend mit der vom Anspruch 1 vorgeschlagenen Maßnahme ändert sich auch das Diffusionsverhalten innerhalb des Spülgases. Zufolge der reduzierten Wärmeleitfähigkeit wird weniger Wärme von der radialen nach außen weisenden Wand des Gasauslassringes an die gekühlte Reaktorwand abgegeben. Dies hat zur Folge, dass die rückwärtige Wand des Hohlraumes des Gasauslassringes eine höhere Temperatur behält als bei der bekannten Prozessführung. Darüber hinaus wirkt die reduzierte Diffusion dem Eindringen von Prozessgas in den Spalt zwischen Prozesskammerdecke und Gasauslassring entgegen. Die erfindungsgemäße Prozessführung ist insbesondere bei solchen Prozessen von Vorteil, bei denen in der Prozesskammer planetenartig Substrate mit relativ großem Durchmesser, beispielsweise sieben Substrate mit jeweils sechs Zoll Durchmesser einliegen. Die Prozesskammer hat dann einen vergleichsweise großen Durchmesser, so dass der Spalt zwischen Gasauslassring und der wassergekühlten Umfangswand eines Standardreaktors recht klein wird. Die erfindungsgemäße Prozessführung hat dann zur Folge, dass im Spalt ein entsprechend erhöhter Temperaturgradient vorliegt. Es ist ferner förderlich, wenn in bekannter Weise der Spaltraum zwischen der Prozesskammerdecke und dem Reaktordeckel ebenfalls mit Stickstoff oder eine Mischung von Wasserstoff und Stickstoff gespült wird. Dieser Spülgasstrom tritt dann durch einen Spalt zwischen dem Rand der Prozesskammerdecke und einem Distanzring gegen die zur Prozesskammerdecke weisende Außenwand des Gasauslassringes. An dieser Stelle vermischt sich das den Deckelspalt spülende Gas mit dem den Umfangsspalt spülenden Gas, so dass das in die Peripherie der Prozesskammer strömende Gas einen vergrößerten Volumenstrom besitzt. Das in die Peripherie der Prozesskammer einströmende Spülgas wird durch die Gasaustrittsöffnungen des Gasauslassringes zusammen mit dem Prozessgas abgesaugt.

Ein Ausführungsbeispiel der Erfindung wird nachstehend anhand beigefügter Zeichnungen erläutert.

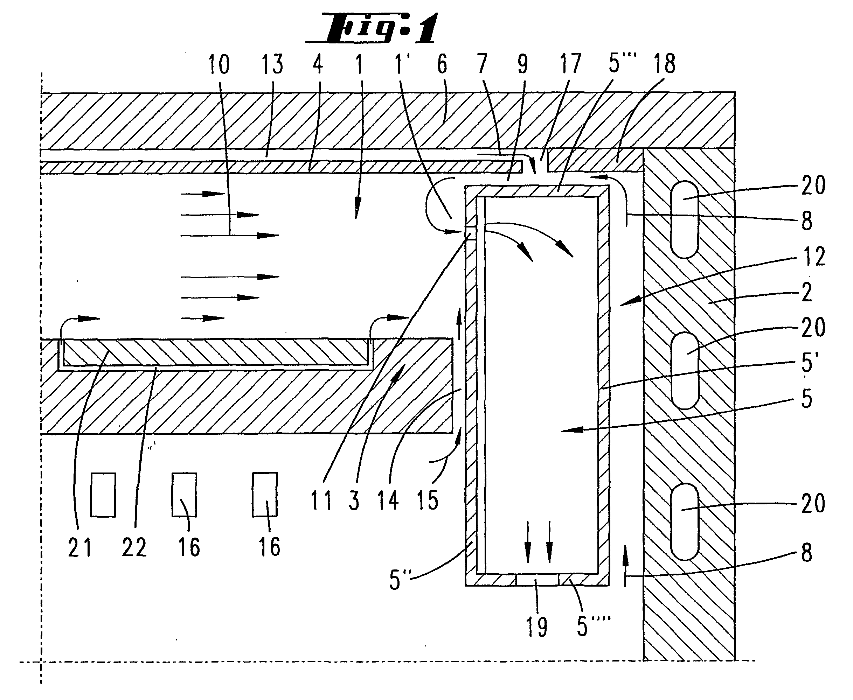

Die Zeichnung ist eine grobe schematische Darstellung der Peripherie einer zylindersymmetrischen Prozesskammer im Querschnitt.

Die Prozesskammer 1 erstreckt sich in der Horizontalen oberhalb des von unten mittels einer HF-Heizung 16 beheizten Prozesskammerbodens 3, welcher aus Grafit besteht. In dem Prozesskammerboden 3, befindet sich eine Vielzahl, insbesondere sieben kreiszylinderförmige Aussparungen, in welchen jeweils ein scheibenförmiger Substrathalter 21 auf einem Gaspolster 22 drehend gelagert ist. Das Prozessgas 10 durchströmt die Prozesskammer 1 von deren Zentrum radial auswärts. Nach oben wird die Prozesskammer 1 durch die Prozesskammerdecke 4 begrenzt, welche aus Quarz oder ebenfalls aus Grafit bestehen kann. Zwischen der Prozesskammerdecke 4 und des aus Edelstahl bestehenden Reaktordeckels 6 befindet sich ein Spalt 13, welcher mittels eines Spülgases 7 vom Zentrum nach außen hin gespült wird.

Die Umfangsbegrenzung der Prozesskammer 1 wird von einem Gasauslassring 5 gebildet. Dieser ist als Hohlkörper ausgebildet. Die in Richtung auf die Prozesskammer 1 weisende Wand 5'' des Gasauslassringes 5 besitzt eine Vielzahl von Öffnungen 11, durch welche das Prozessgas 10 zusammen mit der Peripherie der Prozesskammer 1 einströmenden Spülgas abgesaugt werden. Aus dem Hohlraum des Gasauslassringes 5 tritt das abgesaugte Gas durch ein oder mehrere Gasaustrittsöffnungen 19, die der bodenseitigen Wand 5'''' zugeordnet ist. Dieser Öffnung 19 kann eine Pumpe angeschlossen sein.

Rückwärtig des Gasauslassringes 5 befindet sich zwischen der rückwärtigen Wand 5' und der Reaktorwand 2 ein schmaler Zwischenraum 12. Dieser Zwischenraum wird von einem Spülgas 8 gespült. Die Spülung erfolgt von unten nach oben, so dass das Spülgas 8 an einem im Eckbereich des Reaktors angeordneten Distanzring 18, der aus Ceran bestehen kann, umgeleitet wird, um über die obere Wand 5''' des Gasauslassringes 5 zu strömen.

Zwischen der Prozesskammerdecke und dem Distanzring 18 befindet sich ein ringförmiger Spalt 17, durch welchen das Spülgas 7 austreten kann, um sich mit dem Spülgas 8 des Zwischenraumes 12 zu Mischen und durch den Spalt 9 zwischen der oberen Wand 5''' und dem Randabschnitt der Prozesskammerdecke in den äußeren Abschnitt 1' der Prozesskammer 1 zu strömen, wo es durch die Öffnung 11 zusammen mit einem weiteren Spülgasstrom 15 und dem Prozessgas 10 abgesaugt wird. Das Spülgas 15 spült den Spalt 14, welcher zwischen dem Umfangsrand des Prozesskammerbodens 3 und der nach innen weisenden Wand 5'' des Gasauslassringes 5 liegt.

Erfindungsgemäß ist vorgeschlagen, dass der nur wenige Millimeter breite Zwischenraum 12 zwischen der Wand 5' und der Reaktorwand 12, die Spülwasserkanäle 20 aufweist, mittels Stickstoff oder einer Mischung aus Wasserstoff und Stickstoff gespült wird. Diese Mischung hat eine erheblich niedrigere thermische Leitfähigkeit als reiner Wasserstoff, so dass die Wand 5' des Gasauslassringes 5 insbesondere auf ihrer Innenseite eine Temperatur behält, die höher ist, als die Depositionstemperatur der Prozessgase, wobei es sich um Phosphin, Arsen und metallorganische Verbindungen handeln kann. Dies hat die Folge, das im Hohlraum des Gausauslassringes keine oder nur eine geringe Deposition stattfindet. Wird der Gasauslassring 5 zum Beladen der Prozesskammer 1 mit Substraten abgesenkt, können deshalb keine Partikel aus dem Innenraum des Gasauslassringes 5 durch die Öffnungen 11 nach draußen gelangen.

Indem der Wasserstoff/Stickstoffgasstrom auch den Spalt 9 zwischen Reaktordecke 4 und Gasauslassring 5 spült, wird zudem wirksam verhindert, dass Prozessgas in den Spalt 9 hineindiffundieren, um dort an kalten Stellen zu kondensieren. Indem diesem Gasstrom der ebenfalls aus einer Mischung aus Wasserstoff und Stickstoff bestehende Gasstrom 7 beigemischt wird, wird die Diffusionsfähigkeit weiter herabgesetzt.

## Patentansprüche

1. Verfahren zum Abscheiden von insbesondere kristallinen Schichten auf insbesondere kristallinen Substraten in einer Prozesskammer (1) eines Reaktorgehäuses mit wassergekühlter Wand (2), wobei der Boden (3) der Prozesskammer (1) beheizt wird, und wobei als Prozessgas ein oder mehrere Reaktionsgase zusammen mit Wasserstoff als Trägergase zentral in die Prozesskammer (1) eingeleitet und durch einen der Prozesskammer (1) umgebenden Gasauslassring (5) abgeführt werden, wobei zwischen Reaktordeckel (6) und Prozesskammerdecke (4) ein Spülgas fließt, **dadurch gekennzeichnet, dass** das Spülgaas (7) zusammen mit einem den Raum (12) zwischen Reaktorwand (2) und Gasauslassring (5) spülenden Spülgas (8) durch einen Spalt (9) zwischen Reaktordecke (4) und des zum Beladen der Prozesskammer (1) absenkbaren Gasauslassringes (5) in den äußeren Bereich (1') der Prozesskammer (1) geleitet werden, um zusammen mit dem Prozessgas (10) durch Öffnungen (11) in den Gasauslassring (54) gesaugt zu werden, wobei das den Raum (12) zwischen Reaktorwand (2) und Gasauslassring (5) spülende Gas Stickstoff oder eine Mischung aus Wasserstoff und Stickstoff ist.

2. Vorrichtung zum Abscheiden von insbesondere kristallinen Schichten auf insbesondere kristallinen Substraten in einer Prozesskammer (1) eines Reaktorgehäuses mit wassergekühlter Wand (2), wobei der Boden (3) der Prozesskammer (1) beheizt wird, und wobei als Prozessgas ein oder mehrere Reaktionsgase zusammen mit Wasserstoff als Trägergas zentral in die Prozesskammer (1) eingeleitet und durch einen die Prozesskammer umgebenden Gasauslassring (5) abgeführt werden, wobei zwischen Reaktordeckel (6) und Prozesskammerdecke (4) ein Spülgas (7) fließt, **dadurch gekennzeichnet, dass** das Spülgas (7) zusammen mit einem den Raum (12) zwischen Reaktorwand (2) und Gasauslassring (5) spülenden Spülgas (8) durch einen Spalt (9) zwischen Reaktordecke (4) und des zum Beladen der Prozesskammer (1) absenkbaren Gasauslassringes (5) in den äußeren Bereich (1') der Prozesskammer (1) geleitet sind, um zusammen mit dem Prozessgas (10) durch Öffnungen (11) in den Gasauslassring (54) zu treten, wobei das den Raum (12) zwischen Reaktorwand (2) und Gasauslassring (5) spülende Gas Stickstoff oder eine Mischung aus Wasserstoff und Stickstoff ist.

3. Verfahren nach Anspruch 1, **dadurch gekennzeichnet, dass** das den Spalt (13) zwischen Reaktordeckel (6) und Prozesskammerdecke (4) spülende Gas (7) ebenfalls Stickstoff oder eine Mischung aus Wasserstoff und Stickstoff ist.

4. Vorrichtung nach Anspruch 2, **dadurch gekennzeichnet, dass** das den Spalt (13) zwischen Reaktordeckel (6) und Prozesskammerdecke (4) spülende Gas (7) ebenfalls Stickstoff oder eine Mischung aus Wasserstoff und Stickstoff ist.

## Claims

1. Method for depositing in particular crystalline layers on in particular crystalline substrates in a process chamber (1) of a reactor housing with a water-cooled wall (2), the base (3) of the process chamber (1) being heated, and one or more reaction gases being introduced centrally into the process chamber (1) as process gas, together with hydrogen as carrier gas, and being discharged through a gas outlet ring (5) which surrounds the process chamber (1), a purge gas (7) flowing between reactor cover (6) and processing chamber ceiling (4), **characterized in that** the purge gas (7), together with a purge gas (8) which purges the space (12) between reactor wall (2) and gas outlet ring (5), is passed through a gap (9) between reactor ceiling (4) and the gas outlet ring (5), which can be lowered to allow loading of the process chamber (1), into the outer region (1') of the process chamber (1), in order to be sucked into the gas outlet ring (54) together with the process gas (10) through openings (11), the gas which purges the space (12) between reactor wall (2) and gas outlet ring (5) being nitrogen or a mixture of hydrogen and nitrogen.

2. Device for depositing in particular crystalline layers on in particular crystalline substrates in a process chamber (1) of a reactor housing with a water-cooled wall (2), the base (3) of the process chamber (1) being heated, and one or more reaction gases being introduced centrally into the process chamber (1) as process gas, together with hydrogen as carrier gas, and being discharged through a gas outlet ring (5) which surrounds the process chamber (1), a purge gas (7) flowing between reactor cover (6) and processing chamber ceiling (4), **characterized in that** the purge gas (7), together with a purge gas (8) which purges the space (12) between reactor wall (2) and gas outlet ring (5), is passed through a gap (9) between reactor ceiling (4) and the gas outlet ring (5), which can be lowered to allow loading of the process chamber (1), into the outer region (1') of the process chamber (1), in order to pass into the gas outlet ring (54) together with the process gas (10) through openings (11), the gas which purges the space (12) between reactor wall (2) and gas outlet ring (5) being nitrogen or a mixture of hydrogen and nitrogen.

3. Method according to Claim 1, **characterized in that** the gas (7) which purges the gap (13) between reactor cover (6) and process chamber ceiling (4) is likewise nitrogen or a mixture of hydrogen and nitrogen.

4. Device according to Claim 2, **characterized in that** the gas (7) which purges the gap (13) between reactor cover (6) and process chamber ceiling (4) is likewise nitrogen or a mixture of hydrogen and nitrogen.

## Revendications

1. Procédé de séparation de couches cristallines particulières de substrats cristallins particuliers dans une chambre de traitement (1) d'une enveloppe de réacteur à paroi refroidie à l'eau (2) dans lequel le fond (3) de la chambre de traitement (1) est chauffé et dans lequel, en tant que gaz de traitement, sont employés un ou plusieurs gaz réactionnels avec de l'hydrogène comme gaz porteur, lesquels sont introduits centralement dans la chambre de traitement (1) et sont évacués par un conduit annulaire d'évacuation des gaz (5) entourant la chambre de traitement (1), dans lequel, entre le couvercle du réacteur (6) et le couvercle de la chambre de traitement (4) s'écoule un gaz de balayage, ce procédé étant **caractérisé en ce que** le gaz de balayage (7) et un gaz de balayage (8) balayant l'espace (12) entre la paroi de réacteur (2) et le conduit annulaire d'évacuation des gaz (5), sont amenés ensemble, par une fente (9), dans la zone externe (1') de la chambre de traitement (1) pour être aspirés ensemble avec le gaz de traitement (10) par des ouvertures dans le conduit annulaire d'évacuation des gaz (5), la fente (9) étant entre le couvercle de réacteur (4) et le conduit annulaire d'évacuation des gaz (5) qui peut être abaissé pour charger la chambre de traitement (1), et dans lequel le gaz balayant l'espace (12) entre la paroi de réacteur (2) et le conduit annulaire d'évacuation des gaz (5) est de l'azote ou un mélange d'hydrogène et d'azote.

2. Dispositif pour la séparation de couches cristallines particulières de substrats cristallins particuliers dans une chambre de traitement (1) d'une enveloppe de réacteur à paroi refroidie à l'eau (2) dans lequel le fond (3) de la chambre de traitement (1) est chauffé et dans lequel, en tant que gaz de traitement, sont employés un ou plusieurs gaz réactionnels avec de l'hydrogène comme gaz porteur, lesquels sont introduits centralement dans la chambre de traitement (1) et sont évacués par un conduit annulaire d'évacuation des gaz (5) entourant la chambre de traitement (1), dans lequel, entre le couvercle du réacteur (6) et le couvercle de la chambre de traitement (4) s'écoule un gaz de balayage, **caractérisé en ce que** le gaz de balayage (7) et un gaz de balayage (8) balayant l'espace (12) entre la paroi de réacteur (2) et le conduit annulaire d'évacuation des gaz (5), sont amenés ensemble, par une fente (9), dans la zone externe (1') de la chambre de traitement (1) pour être aspirés ensemble avec le gaz de traitement (10) par des ouvertures dans le conduit annulaire d'évacuation des gaz (5), la fente (9) étant entre le couvercle de réacteur (4) et le conduit annulaire d'évacuation des gaz (5) qui peut être abaissé pour charger la chambre de traitement (1), et dans lequel le gaz balayant l'espace (12) entre la paroi de réacteur (2) et le conduit annulaire d'évacuation des gaz (5) est de l'azote ou un mélange d'hydrogène et d'azote.

3. Procédé selon la revendication 1, **caractérisé en ce que** le gaz (7) de balayage passant dans la fente (13) entre le couvercle du réacteur (6) et le couvercle de la chambre de traitement (4) est également de l'azote ou un mélange d'hydrogène et d'azote.

4. Dispositif selon la revendication 2, **caractérisé en ce que** le gaz (7) de balayage passant dans la fente (13) entre le couvercle du réacteur (6) et le couvercle de la chambre de traitement (4) est également de l'azote ou un mélange d'hydrogène et d'azote.
